Europäisches Patentamt

European Patent Office

Office européen des brevets

(19)

(11) EP 0 625 218 B1

(12) EUROPÄISCHE PATENTSCHRIFT

(45) Veröffentlichungstag und Bekanntmachung des Hinweises auf die Patenterteilung:
26.06.1996 Patentblatt 1996/26

(21) Anmeldenummer: 93917359.7

(22) Anmeldetag: 30.01.1993

(51) Int Cl.⁶: **C23C 16/48**, C23C 16/50, C23C 16/26, C23F 4/00

(86) Internationale Anmeldenummer:
PCT/EP93/00214

(87) Internationale Veröffentlichungsnummer:
WO 93/16213 (19.08.1993 Gazette 1993/20)

(54) **VERFAHREN UND VORRICHTUNG ZUR OBERFLÄCHENMODIFIKATION DURCH PHYSIKALISCH-CHEMISCHE REAKTIONEN VON GASEN ODER DÄMPFEN AN OBERFLÄCHEN MIT UNTERSTÜTZUNG VON HOCHGELADENEN IONEN**

PROCESS AND DEVICE FOR SURFACE-MODIFICATION BY PHYSICO-CHEMICAL REACTIONS OF GASES OR VAPOURS ON SURFACES, USING HIGHLY-CHARGED IONS

PROCEDE ET DISPOSITIF DE MODIFICATION DE SURFACES PAR REACTIONS PHYSICO-CHIMIQUES DE GAZ OU DE VAPEURS SUR LES SURFACES A L'AIDE D'IONS FORTEMENT CHARGES

(84) Benannte Vertragsstaaten:
CH FR GB IT LI

(30) Priorität: 15.02.1992 DE 4204650

(43) Veröffentlichungstag der Anmeldung:
23.11.1994 Patentblatt 1994/47

(73) Patentinhaber: HOFFMEISTER, Helmut
D-48147 Münster (DE)

(72) Erfinder: ANDRÄ, Jürgen
D-4400 Münster (DE)

(56) Entgegenhaltungen:
EP-A- 0 209 109        EP-A- 0 394 735
DE-A- 4 020 816        US-A- 4 734 158
US-A- 4 800 100

• Patent Abstracts of Japan, vol. 12, No. 312, C-523 abstract of JP, A, 63-83271 (CANON INC ), 13 April 1988 (13.04.88)

**Beschreibung**

Die Erfindung betrifft ein Verfahren zur Oberflächenmodifikation durch physikalisch-chemische Reaktionen mit den Verfahrensschritten:

(a) Kontaktieren einer festen Oberfläche mit kristalliner oder amorpher Struktur mit einem reaktiven, gasförmigen Fluid (Gas, Gasgemisch, Dampf oder Dampfgemisch), das mit der Oberfläche in Wechselwirkung treten soll,
(b) Einbringen von Aktivierungsenergie in den Kontaktbereich von Fluid und Oberfläche mithilfe von Ionen oder Plasmen, um Reaktionen zwischen den genannten Partnern auszulösen,

sowie eine Vorrichtung zur Durchführung des Verfahrens.

Das Verfahren umfaßt demnach beispielsweise die Beschichtung oder Ätzung von Oberflächen durch physikalisch-chemische Reaktionen von reaktiven gasförmigen Fluiden (Gasen, Gasgemischen, Dämpfen, Dampfgemischen) an den Oberflächen mit Untersützung von Plasmen oder Ionenstrahlen, wobei sich

(a) durch Wechselwirkung der Gase, Gasgemische oder Dämpfe an einer Oberfläche mit Ionenstrahlen oder mit einem Plasma Schichten an der Oberfläche niederschlagen lassen, die chemisch aus Radikalen dieser Gase oder Dämpfe zusammengesetzt sind, oder
(b) durch Wechselwirkung der reaktiven Fluide an der Oberfläche mit Ionenstrahlen oder mit einem Plasma Oberflächenatome mit Radikalen der verwendeten Gase oder Dämpfe in flüchtige Moleküle binden und so abtragen (abätzen) lassen,
(c) durch Wechselwirkung der Ionen an der Oberfläche Oberflächen-Atome oder -Moleküle desorbieren und so abgetragen bzw. abgeätzt werden.

Es ist bekannt, daß Ionenstrahl- und Plasmaverfahren in Gegenwart von Gasen oder Dämpfen, je nach Wahl dieser Gase oder Dämpfe, für das Ätzen von Oberflächen oder für die Beschichtung von Oberflächen oder die Dünnschichten-Herstellung auf Oberflächen verwendet werden. Eine Zusammenfassung der Grundlagen und des technischen Standes dieser Verfahren findet sich in drei Veröffentlichungen:

I:      R.A. Haefer, "Oberflächen- und Dünnschicht-Technologie", Teil 2: "Oberflächenmodifikation durch Teilchen und Quanten", Reihe Werkstoff-Forschung und Technik, Band 6, Springer Verlag 1991;
II:     "Low Energy Ion Beam and Plasma Modification of Materials", eds. J.M.E. Harper, K. Miyake, J. R. McNeil and S.M. Gorbatkin, Symposium Proceedings of the Materials Research Society, Vol.

223, Materials Research Society, Pittsburgh, USA, 1991;
III:    Comptes rendus des travaux du "8ème Colloque International sur les Procédés Plasma", Le Vide les Couches Minces, Supplément 256, 1991,

die im folgenden mit I, II und III bezeichnet werden.

Unter dem Begriff "Oberflächenmodifikation" sollen insbesondere die Oberflächenbeschichtung und das Oberflächenätzen subsumiert werden.

Bei der **Oberflächenbeschichtung** aus Gasen oder Dämpfen muß lokal an der Oberfläche Energie für die chemisch-physikalische Reaktion der Gase oder Dämpfe zur Erzeugung einer Verbindung mit der Oberfläche zur Verfügung gestellt werden, um die Beschichtung der Oberfläche mit einer gewünschten Verbindung zu erhalten. Es ist daher z.B. durch thermische Energiezufuhr möglich, $Si_3N_4$-Beschichtungen auf $SiO_2$-Filmen durch Anströmen der Gase $SiH_4$ und $N_2$ an auf hohe Temperatur (>600° C) erhitzte $SiO_2$-Filmoberflächen zu erzeugen. Man nennt dieses Verfahren "Chemische Dampf-Abscheidung" (engl. "Chemical Vapor Deposition", CVD). Für viele Anwendungen besitzt das CVD-Verfahren aber den Nachteil, nur bei hohen Temperaturen zu funktionieren.

Es ist bekannt, bei reduzierten Oberflächentemperaturen zu arbeiten, indem die Energie für die chemisch-physikalische Oberflächenreaktion von einfallenden Ionen einfacher Ladung und kinetischer Energie zur Verfügung gestellt wird. Die Ionen können dabei aus einem Plasma oder einem speziell präparierten Ionenstrahl stammen.

Im Falle eines konventionellen Plasmas spricht man von "Plasma-Verstärkter Chemischer Dampf-Abscheidung" (engl. "Plasma Enhanced (or Activated) Chemical Vapor Deposition", PECVD oder PACVD). Dabei erreicht man eine Reduktion der Oberflächentemperatur für die oben beschriebene $Si_3N_4$-Beschichtung auf etwa 300° C. Mit neueren Elektron-Zyklotron-Resonanz-Plasmen [EZR - Plasmen (engl."Electron Cyclotron Resonance", ECR)] kann diese Temperatur weiter auf etwa 150° C reduziert werden. Man spricht dann von ECR-PECVD, das zwar schon eingesetzt wird, aber in seiner ganzen Anwendungsbreite noch erforscht wird. Über Fortschritte bei der Herstellung von Diamantbeschichtungen aus dem Gasgemisch $CH_4$ und $H_2$ mit ECR-PECVD wurde berichtet [F. Roy, M. Mermoux, B. Marcus, III, Seiten 353 bis 355].

Die Ersetzung des Plasmas durch einen Ionenstrahl einfacher Ladung und Energie gestattet eine noch bessere Lokalisierung und Konzentration an oder auf der Substrat-Oberfläche der für die CVD zur Verfügung gestellten Energie und erlaubt so eine weitere Absenkung der Temperatur des Substrats. Diese Energie steht im wesentlichen durch die Absorption der kinetischen Energie der Ionen in den ersten Oberflächenschichten in Form einer Oberflächenaktivierung zur Verfügung. Man spricht deshalb von Ionenaktivierter CVD (engl.

"Ion Activated CVD, IACVD). Diese IACVD gewinnt insbesondere dadurch an Interesse, da Gase oder Gasgemische, die an der Oberfläche adsorbieren, erst durch den Ionenbeschuß gemeinsam mit der Oberfläche aktiviert werden und die entstehenden festen Verbindungen als Schichten deponiert werden. Diese Technik liefert speziell bei tiefen Temperaturen (z.B. -100° C) der Substrate, bei denen sich die Gase oder Gasgemische gut adsorbieren lassen, gute Beschichtungsresultate [M. Hirose, H. Shin, S. Miyazaki, and Y. Horiike, III, Seiten 105 bis 112]. Die Ionenart kann frei gewählt werden, so daß Ionen der zu deponierenden Schichten verwendet werden können, was zu reineren Schichten führt. Durch Verwendung niederenergetischer $C^+$-Ionen konnten z. B. Diamantkristallschichten mit hohem Reinheitsgrad hergestellt werden [J.W. Rabalais and S. Kasi, Science 239,(1988), Seite 623]. Die tribologisch wichtigen Übergangsmetall-Nitrid oder -Carbid Beschichtungen lassen sich ebenfalls bei Verwendung von $C^+$- oder $N^+$-Ionenstrahlen gut herstellen.

Zu verweisen ist in diesem Zusammenhang auf die DE-A 4 020 816, die spezielle Maßnahmen zur massenspektroskopisch reinen Zuführung von Beschichtungsmaterial zur Erzeugung einer Dünnschicht beschreibt. Ein Ausgangsgas wird "aktiviert", was als "ionisiert" zu verstehen ist; anschließend wird es massenselektiert und dann nach Abbremsung und eventueller Neutralisierung auf das Substrat gelenkt. Dort dient es in einer CVD (Chemical Vapor Deposition), PECVD (Plasma Enhanced Chemical Vapor Deposition), PACVD (Plasma Activated Chemical Vapor Deposition) oder IACVD (Ion Activated Chemical Vaport Deposition) zur Schichtbildung. Die Ionisierung wird nicht systematisch auf einen Ladungszustand $q_m > 2$ getrieben; sie dient lediglich der Vorbereitung der Massenselektion.

Bei der Oberflächenätzung mit gasförmigen reaktiven Fluiden (Gasen oder Dämpfen) muß lokal an der Oberfläche Energie für die chemisch-physikalische Reaktion der Gase oder Dämpfe mit der Oberfläche zur Verfügung gestellt werden. Die Energie dient im wesentlichen dazu, aus flüchtigen Molekülen reaktive Radikale abzutrennen, die mit den Oberflächenatomen andere flüchtige Moleküle bilden und so die Oberfläche abtragen. Beispielsweise werden an erhitzten Silizium-Oberflächen aus $CF_4$ (Tetrafluormethan) sehr reaktive, neutrale Fluoratome abgetrennt, die am Si-Substrat flüchtiges $SiF_4$ bilden und so für ein großflächiges Abtragen der Si-Oberfläche sorgen.

Wenn die Dissoziation z.B. durch ein Plasma energetisch unterstützt wird, werden reaktive Ionen gebildet, die zu einer verstärkten Ätzung der Oberfläche führen. Im vorhergehenden Beispiel tragen dann neben neutralem Fluor auch $CF_3^+$-Ionen zum Ätzen bei. Man spricht in diesem Fall von "Reaktiv-Ionen-Ätzen" (engl."Reactive Ion Etching", RIE). Die Ionen können eine kinetische Energie von einigen 100 eV besitzen und so nicht nur die Dissoziation der Gasmoleküle, sondern auch eine physikalisch-chemische Aktivierung der Oberflächenatome bewirken. Da diese Aktivierung von der Ioneneinfallsrichtung abhängt, kann räumlich gerichtet insbesondere dann geätzt werden, wenn die Ionenproduktion vom Substratbereich räumlich getrennt erfolgt. Ein gerichteter Ionenstrahl kann mit dem Substrat wechselwirken; das Substrat wird gleichzeitig von den Ätzgasen angeströmt. Man spricht dann vom "Reaktiven Ionen-Strahl Ätzen" (engl."Reactive Ion Beam Etching", RIBE). Als Beispiele können das Ätzen von $Al_2O_3$ oder Au durch $Cl^+$ Ionen unter gleichzeitigem Anströmen mit $CCl_4$ oder $C_2F_4Cl_2$ genannt werden [I, Kapitel 7.6, Seiten 205 bis 217].

Beim RIBE-Verfahren ist vorteilhaft, daß die Gase oder Gasgemische, die an der Oberfläche adsorbieren, erst durch den Ionenbeschuß gemeinsam mit der Oberfläche aktiviert werden, sich mit Molekülen aus dem Substrat verbinden und so ein sehr gut kontrollierbares Abtragen der Oberfläche erlauben. Diese Technik liefert speziell bei tiefen Temperaturen der Substrate (z.B. -100° C), bei denen sich die Gase oder Gasgemische gut adsorbieren lassen, präzise Ätzresultate [M. Hirose, H. Shin, S. Miyazaki, and Y. Horiike, III, Seiten 105 bis 112; R. Petri, J.-M. Francou, D. Henry, and A. Inard, III, Seiten 94 bis 97].

Bei diesen durch Ionen unterstützten Beschichtungs- oder Ätzverfahren ist nachteilig, daß die kinetische Energie der Ionen, die notwendig ist, die lokale Oberflächenaktivität bzw. die lokale physikalisch-chemische Aktivität zu erzeugen, so hoch ist, daß eine Beschädigung des Materials unterhalb der Oberfläche und in den bereits aufgetragenen Schichten nicht zu vermeiden ist. Diese Materialschäden sind von hoher Tragweite. Versuche haben gezeigt, daß elektronische oder opto-elektronische Bauelemente, die nach diesen Verfahren hergestellt wurden, zu hohe Fehlerdichten besaßen und damit nicht brauchbar waren. Es mußten deshalb langwierige Ausheilverfahren verwandt werden, die die verfahrenstechnischen Vorteile der Herstellungstechnik zunichte machten [D. Lootens, P. Clauws, P. Van Daele, and P. Demeester, III, Seiten 292 bis 294].

Es stellt sich damit die Aufgabe, die vorgenannten Verfahren dahingehend zu verbessern, daß eine Beschädigung des zu modifizierenden Materials unterhalb der Oberfläche und in den bereits aufgetragenen Schichten vermieden wird. Hierdurch könnten der Zeitaufwand für das Ausheilen dieser Schäden reduziert und somit die Produktivität deutlich gesteigert werden.

Die Erfindung löst die Aufgabe dadurch, daß die Aktivierungsenergie in Form potentieller Energie wenigstens zweifach geladener Ionen mit niederer kinetischer Energie oder mit Plasmaströmen, die einen hohen, arithmetisch mittleren Landungszustand $q_m>2$ und damit einen hohen Anteil an wenigstens zweifach geladenen Ionen mit niederer kinetischer Energie aufweisen, eingebracht wird, wobei die den Ionen gegebene kinetische Energie lediglich danach bemessen wird, daß den Ionen eine nächste Annäherung an die Atome der Oberfläche, nicht jedoch ein Eindringen in die Oberfläche ermöglicht ist.

Mit anderen Worten: Die Oberfläche des zu behandelnden Materials wird mit wenigstens zweifach geladenen Ionen niedriger kinetischer Energie beschossen, wobei die potentielle Energie der Ionen entsprechend ihrer hohen Ladung für die Aktivierung der Oberfläche, der an der Oberfläche adsorbierten oder der sich vor der Oberfläche befindlichen Gasmoleküle Verwendung findet. Den Ionen ist eine nächste Annäherung an die Atome der Oberfläche, nicht jedoch ein Eindringen in die Oberfläche ermöglicht.

Wie bereits erwähnt, wird unter Oberflächenmodifikation insbesondere das Ätzen, Beschichten oder Ablagern verstanden. Die Beschichtung oder Ätzung von Oberflächen wird durch die Wechselwirkung hochgeladener Ionen niedriger kinetischer mit der Oberfläche, mit den an der Oberfläche adsorbierten Gasen oder Dämpfen oder mit den Gasmolekülen vor der Oberfläche bewirkt. Im Gegensatz zur Benutzung der relativ hohen kinetischen Energie für die physikalisch-chemische Aktivierung in bisherigen RIE-, RIBE-, PECVD-oder IACVD-Verfahren, findet die im hochgeladenen Ion gespeicherte potentielle Energie für die Beschichtung oder Ätzung der Oberflächen Verwendung. Die relativ niedrige kinetische Energie der hochgeladenen Ionen wird lediglich für die nächste Annäherung an die zu aktivierenden Oberflächenatome oder Moleküle benötigt.

Die elektronische Wechselwirkung hochgeladener Ionen mit einer Oberfläche beeinflußt einerseits den elektronischen Zustand des Ions durch Elektronenaustausch zwischen der Oberfläche und dem Ion und andererseits die Trajektorie (Flugbahn) des Ions durch die anziehende Kraft der Bildladung, die bei elektrisch leitenden Oberflächen gleich der effektiven Ladung des Ions vor der Oberfläche ist. Bei elektrisch nicht leitenden Oberflächen ist sie stark reduziert und kann bis zu Null werden. Der Elektronenaustausch von der Materialoberfläche zum hochgeladenen, anfliegenden Ion beginnt, bei Zugrundelegung atomarer Einheiten $a_o = 0.0529$ nm, in großen Abständen z (einige nm) vor der ersten Atomlage der Oberfläche, die bei $z_c = 0$ angenommen wird. Erfindungswesentlich ist, daß das hochgeladene Ion auf seinem weiteren Weg von $z_c$ bis zu einem Abstand $z = d$ vor der ersten Atomlage der Oberfläche resonant Elektronen von der Oberfläche in hochangeregte Zustände einfängt und so seine anfängliche Ladung reduziert bzw. von leitenden Oberflächen neutralisiert wird, wobei der mittlere Gitterabstand der Atome in der Oberflächenebene ist. Da diese Elektronen aus dem Leitungsband bzw. Valenzband des Oberflächenmaterials oder aus den Valenzelektronen adsorbierter Atome oder Moleküle stammen, ist die Resonanzenergie durch die Bindungsenergie dieser Bänder oder Valenzelektronen festgelegt.

Durch dieses "Absaugen" von (Valenz-) Elektronen aus der Oberfläche werden lokale Bindungen adsorbierter Atome oder Moleküle so stark abgeschwächt, daß sie physikalisch-chemisch aktiviert (angeregt) werden.

Dadurch können Atome oder Radikale der adsorbierten Moleküle neue chemische Bindungen eingehen und so zu einer Beschichtung der Oberfläche führen oder aber, je nach Wahl der adsorbierten Atome oder Moleküle, mit den Oberflächenatomen flüchtige Moleküle bilden und so zu einer Abtragung (Ätzung) der Oberfläche führen, bevor das einfallende, ursprünglich hochgeladene Ion in unmittelbare Nähe (z < d) der Oberflächenatome gelangt. Bei halbleitenden bis zu nichtleitenden, sauberen Oberflächen kann dieses "Absaugen" von Valenz-Elektronen direkt zur Coulomb-Desorption, d.h., zur Abtragung (Ätzung) von Oberflächen-Atomen oder -Molekülen ohne Zuhilfenahme von absorbierten Atomen oder Molekülen führen.

Es kann angenommen werden, daß das Ion im Bereich 0 < z < d in die exponentiell ins Vakuum abklingende Elektronendichte der Oberfläche eintaucht, so daß die elektronische Abschirmung der Oberflächenatome und des Ionenkerns reduziert werden. Dies führt zu einer abstoßenden Coulomb-Kraft zwischen dem Ionenkern und allen Oberflächenatomkernen bzw. Adsorbatatomkernen. Für $Ar^+$-Ionen im Abstand 1.0 $a_o$ vor den Oberflächen- bzw. Adsorbatatomkernen erreicht dieses Potential Werte im Bereich von 20 (für Mg) bis 116 eV (für Pt), im Mittel also etwa $65 \pm 45$ eV und entsprechend höhere Werte für höher geladene Ar-Ionen mit effektiver Ladung > 1. Je nach seiner effektiven Ladung $q_{eff}$ in diesem räumlichen Bereich vor der Oberfläche wird also ein ursprünglich hochgeladenes Ion an der Oberfläche total reflektiert, wenn seine ursprüngliche kinetische Energie $E_o \leq (65 \pm 45) \cdot q_{eff}$ eV beträgt. Da $q_{eff}$ bislang nicht bekannt ist, sind die niedrigst möglichen, kinetischen Energien der hochgeladenen Ionen zu fordern, um eine Totalreflektion des Ions an der Oberfläche zu gewährleisten. Das Erreichen von Totalreflektion am kollektiven Oberflächenpotential ist wesentlich, da praktisch keine Oberflächenatome durch Übertragung kinetischer Energie in einem Stoß zwischen dem Ion und einem einzelnen Oberflächenatom herausgelöst werden können. Diese Abnahme der Zerstäubungsrate mit abnehmender kinetischer Energie einfach geladener Ionen ist eindeutig nachgewiesen worden [H. Gnaser and H. Oechsner, Surface Science 251/252, 1991, 696-700; siehe auch J. Muri and Ch. Steinbrüchel, II, Seiten 41 bis 46].

Von der definierten Grenzenergie $E_o$ muß bei elektrisch leitenden Oberflächen eine Energie $E_B$ subtrahiert werden, die durch die Bildladungsbeschleunigung des Ions entsteht. Sie setzt sich aus zwei Termen zusammen, die geometrisch den Bereichen $z > z_c$ und $z_c \geq z \geq d$ entsprechen. Im ersten Bereich gilt die ursprüngliche Ladung q des Ions, so daß der Energiegewinn bis zum Abstand $z_c$ $E_{B1} = 27.2 \cdot q/z_c$ eV wird. Im zweiten Bereich ist die effektive Ladung des Ions unbekannt, so daß nur eine grobe Abschätzung möglich ist. Unter Annahme begrenzter Abschirmung durch hochangeregte Elektronen im eigentlich neutralisierten Ion kann man $q_{eff} \approx q/2$ setzen und erhält so

$$E_{B2} \approx 27.2 \cdot (q/2) \cdot [d^{-1} - z_c^{-1}] \text{ eV}.$$

Als Grenzanfangsenergie für Totalreflektion ergibt sich so im Mittel $E_o \leq 65.q/2 - E_{B1} - E_{B2}$, was etwa $E_o \leq (39 \pm 20) \cdot q$ eV entspricht. Je nach Oberflächenmaterial muß also die Grenzanfangsenergie der hochgeladenen Ionen unterhalb $10 \cdot q$ und $60 \cdot q$ eV gewählt werden, um Totalreflexion der Ionen an der Oberfläche und damit eine vernächlässigbare Materialbeschädigung unterhalb der Oberfläche, d.h. eine beschädigungsarme Behandlung der Oberfläche zu gewährleisten.

Je nach Oberflächen- und adsorbiertem Material und Wahl von $E_o$ werden bei Totalreflexion die Abstände nächster Annäherung $z_o$ zwischen Oberflächen-Atomen oder -Molekülen und dem Ion zwischen 0.5 und 2.0 $a_o$ liegen. Dies sind Abstände, bei denen das ursprünglich hochgeladene, auf dem Weg von $z_c$ bis zu $z_o$ aber in äußeren Schalen neutralisierte Ion Elektronen direkt aus gefüllten, inneren Schalen der Oberflächen-Atome oder -Moleküle in seine eigenen, immer noch teilweise leeren, inneren Schalen einfangen kann. Dafür verantwortlich sind quasi-resonante Elektronenaustauschprozesse oder interatomare Auger-Neutralisation, die mit einer Wahrscheinlichkeit nahe 1 für jedes einzelne Ion beim Umkehrpunkt seiner Trajektorie auftreten, wenn das Ion nahe genug an ein Oberflächenatom oder an ein an der Oberfläche adsorbiertes Atom oder Molekül herankommt.

Dadurch tritt eine sehr starke physikalische Anregung der Oberflächenatome oder der an der Oberfläche adsorbierten Atome oder Moleküle auf, die durch Verlust von Elektronen zu starker Coulombabstoßung und damit zu Desorption des betreffenden Atoms führt oder, wenn die deponierte potentielle Energie dazu nicht ausreicht, sich in extrem lokalisierte thermische und chemische Aktivierung umsetzt. Diese Bedingung einer Mindestannäherung an die zu aktivierenden Atome ist genau so wichtig für das beanspruchte Verfahren wie die Totalreflexionsbedingung. Die zwar sehr niedrige Energie der einfallenden Ionen darf also nicht nur nach dem Kriterium der Totalreflexion gewählt werden, sondern muß auch so angepaßt sein, daß die Ionen nahe genug an die Oberflächenatome oder an die an der Oberfläche adsorbierten Atome oder Moleküle herankommen können, wobei nahe definiert ist durch den Orbitaldurchmesser der einzufangenden Innerschalenelektronen. Die daraus resultierenden optimalen Ionenenergien werden von der Ionensorte und dem physikalisch-chemisch zu aktivierenden Material abhängen, so daß sowohl theoretische Abschätzungen als auch experimentelle Bestimmungen der optimalen Energie von Fall zu Fall notwendig werden.

Erfindungswesentlich ist, daß jedes niederenergetische, ursprünglich hoch geladene Ion im Bereich weniger Nanometer vor der Oberfläche viele Valenzelektronen und am Umkehrpunkt seiner Trajektorie vor der Oberfläche mindestens ein, wenn nicht mehrere Innerschalenelektronen aus einem dort befindlichen Oberflächen-Atom oder -Molekül oder adsorbierten Atom oder Molekül extrahiert, so daß sich mit einer örtlichen Genauigkeit von wenigen Nanometern eine hohe physikalisch-chemische Aktivierung für Beschichtung oder Ätzung erzeugen läßt und mit einer örtlichen Genauigkeit von Subnanometern eine besonders starke Aktivierung erreichen läßt, die speziell das Ätzen durch zusätzliche Desorption unterstützt. Gegenüber der kinetischen Energiedeposition, die sich durch den Abbremsprozeß energiereicher, einfach geladener Ionen über einige zehn bis tausend Nanometer erstreckt, ist also die Energiedeposition mit hochgeladenen Ionen niedriger kinetischer, aber hoher potentieller Energie sehr gut lokalisiert und gestattet daher die Beschichtung oder Ätzung mit örtlichen Auflösungen der Größenordnung von Nanometern. Dies ist ein ganz entscheidender Vorteil des beanspruchten Verfahrens.

Wenn es nicht auf örtliche Auflösung oder Anisotropie der Beschichtung oder Ätzung ankommt, kann auch der große Elektroneneinfangswirkungsquerschnitt von $10^{-14}$ bis $10^{-15}$ cm$^2$ von freien Atomen oder Molekülen, die sich in einer Entfernung von $\geq 5$ mm von der Oberfläche befinden, in hochgeladene Ionen positiv genutzt werden. Die Atome werden durch diesen Elektronenverlust ionisiert und die Moleküle in ihre teils ionisierten Radikale zerlegt, so daß sehr reaktive Partikel für Beschichtung oder Ätzung erzeugt werden. Damit diese Reaktionspartner in unmittelbarer Nähe der Oberfläche erzeugt werden, muß sichergestellt werden, daß die Oberfläche mit Gasen, Gasgemischen oder Dämpfen von niedrigem Druck (etwa 1 Pa) nur in einer möglichst dünnen Schicht von einigen Millimetern Dicke angeströmt wird, denn die mittlere freie Weglänge für hochgeladene Ionen beträgt dann nur einige Millimeter. Gleichzeitig ist dabei zu beachten, daß die Ionentrajektorie bis zu dieser Gasschicht in einem Vakuum von deutlich besser als $10^{-2}$ Pa verlaufen muß, damit das Ion noch in hochgeladenem Zustand in diese Gasschicht eindringt. Wenn diese differentiellen Pumpbedingungen erfüllt werden, können dadurch, daß jedes hochgeladene Ion mehrere reaktive Radikale erzeugen kann, großflächige Beschichtungen oder Ätzungen mit Ionenstromdichten von typischerweise einigen $q \cdot \mu A \cdot cm^{-2}$ sehr effizient mit Beschichtungs- oder Ätzraten von einigen 100 nm s$^{-1}$ durchgeführt werden, wobei q die Ladung des einfallenden Ions ist.

Wenn es dagegen auf hohe örtliche Auflösung oder Anisotropie der Beschichtung oder Ätzung ankommt, muß die Produktion von Reaktanten aus dem gasförmigen Fluid in Abständen von der Oberfläche größer als die geforderte Auflösungsgrenze vermieden werden. Dies wird möglich durch die besonders effiziente physikalisch-chemische Aktivierung von Atomen oder Molekülen, die an der Oberfläche adsorbiert oder kondensiert sind. Durch Anpassung der Aktivierungsrate durch eine entsprechende Ionenstromdichte von etwa q $\mu A \cdot cm^{-2}$ hochgeladener Ionen an die Adsorptionsrate des Gases, Gasgemisches oder Dampfes lassen sich Vakuumbedingungen erreichen, bei denen die Ionen mit einer Wahrscheinlichkeit nahe 1 mit ihrer ursprünglichen Ladung in unmittelbare Nähe der Oberfläche (< 3 nm) gelangen und dort Beschichtungen oder Ätzungen von etwa 300 nm pro Sekunde aktivieren. Für die Adsorption oder Kondensation der Gase, Gasgemische oder Dämpfe erweist sich das beanspruchte Verfahren besonders vorteilhaft, weil es bei allen Substrattemperaturen eingesetzt werden kann und deshalb speziell bei tiefen Temperaturen des Substrats (z.B. -100° C) zu sehr guten Beschichtungs- oder Ätzungsergebnissen führt, da keine thermische Belastung der Schichten oder des Oberflächenmaterials durch den total reflektierten Ionenstrahl auftritt. Durch gepulsten Gas-, Gasgemisch- oder Dampfstrahl lassen sich die günstigen Vakuumbedingungen weiter verbessern, so daß präzise ionenoptische Abbildungssysteme verwendet werden können, ohne Streuung der Ionen an Gaspartikeln befürchten zu müssen. So können bei einem Ätzprozess hochgeladene Ionen stark reaktiver Gase verwendet werden, so daß beim Ätzvorgang nur ein Minimum an zusätzlichem Fluid benötigt wird; im Grenzfall kommt man sogar ohne zusätzliches Fluid aus.

Die Unteransprüche geben vorteilhafte Ausführungsformen des Hauptanspruches an. Dabei gilt insbesondere:

- Durch gepulsten Gas-, Gasgemisch- oder Dampfstrahl lassen sich die günstigen Vakuumbedingungen weiter verbessern, so daß präzise ionenoptische Abbildungssysteme verwendet werden können, ohne Streuung der Ionen an Gaspartikeln befürchten zu müssen.

- Da hochgeladene Ionen niedriger kinetischer Energie auch für die Reinigung und Glättung von Oberflächen eingesetzt werden können, kann man von der ersten Reinigung der Substratoberfläche mit präzisen ionenoptischen Abbildungen und entsprechend variierenden Gaszufuhren viele sukzessive Prozeßschritte der Oberflächenmodifikation bis zu sehr komplexen Strukturaufprägungen im Nanometerbereich in demselben Rezipienten durchführen und so eine hohe Produktivität erzielen.

Zusammenfassend kann also gefolgert werden, daß die aufgeführten Vorteile der in den Ansprüchen angegebenen Erfindung im wesentlichen darauf beruhen, daß die schädigungsarme Beschichtung und Ätzung von Oberflächen im wesentlichen durch die in hochgeladenen Ionen gespeicherte potentielle Energie erfolgt im Gegensatz zur Verwendung der kinetischen Energie einfach geladener Ionen in bisherigen Verfahren. Die beschriebene Erfindung wird in allen Produktionsverfahren, wo RIE-, RIBE-, PECVD-oder IACVD-Verfahren eingesetzt werden, zu einer wesentlichen Produktivitätssteigerung durch Reduktion des schädigungsbedingten Auschusses führen, welche die investiven Mehrkosten des beanspruchten Verfahrens vielfach kompensieren. Die in den Ansprüchen angegebene Erfindung wird auch eine erhebliche Präzisionssteigerung des ortaufgelösten und anisotropen Beschichtens oder Ätzens bewirken, die tieferes Ätzen und höheren Beschichten bei gleichzeitig höherer Strukturdichte erlauben werden, so daß völlig neue Techniken und Produktionsbereiche erschlossen werden. In allen Produktionsverfahren, wo bisher aus Kostengründen auf einen Einsatz der RIE-, RIBE-, PECVD-oder IACVD-Verfahren verzichtet wird, kann das erfinderische Verfahren durch Qualitätssteigerungen und somit durch Ausschußreduktion zu solchen Kostenreduktionen führen, daß es sich in der Fabrikation von Mikro- und Nanostrukturen durchsetzen wird.

Bei Verwendung elektrisch halbleitender bis nichtleitender Substrat-Oberflächen kann die von einfallenden, positiven Ionen verursachte Aufladung der Oberfläche durch gleichzeitiges oder intermittierendes Besprühen der Oberfläche mit Elektronen niedriger kinetischer Energie kompensiert werden.

Eine weitere Erläuterung der Erfindung erfolgt anhand von Beispielen und Figuren. Die Figuren zeigen im einzelnen:

| Figur 1 | einen schematischen Aufbau einer ersten Anordnung, mit der eine Oberflächenmodifizierung durch Beschichten odr Ätzen ausführbar ist, |
|---|---|
| Figur 2 | eine zweite Ausführungsform, |
| Figuren 3 und 4 | weitere Ausführungsformen, |
| Figuren 5 und 6 | eine Spezialisierungen der beiden ersten Ausführungsformen. |

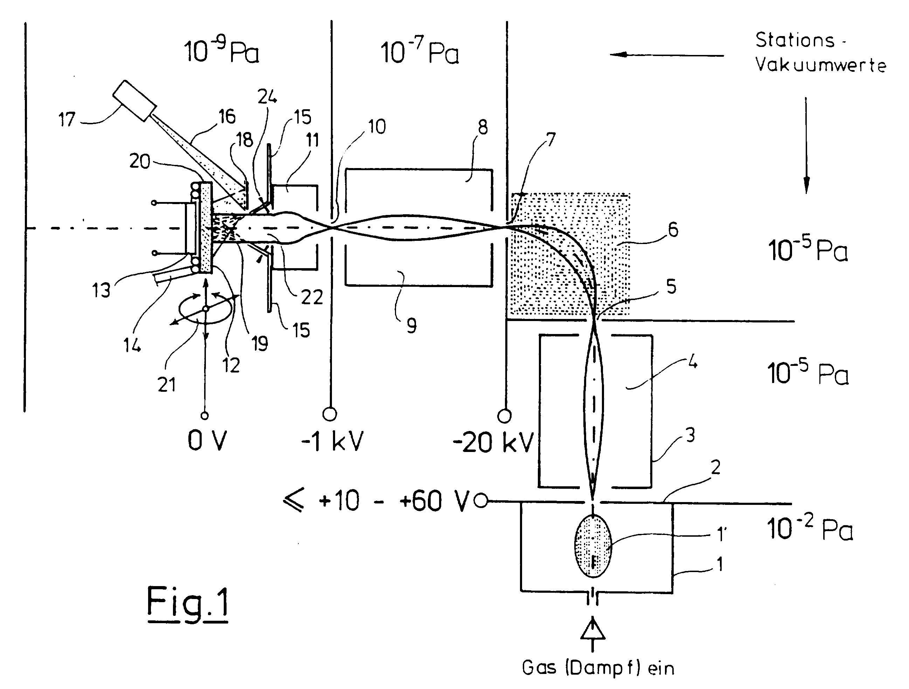

Beispiel 1 (vergl. Figur 1)

In Figur 1 ist in schematischer Darstellung ein erster Vorrichtungsaufbau zur Durchführung des Verfahrens dargestellt, wie er mit heute bekannten Mitteln aufgebaut werden kann. Unter der Bezugszahl 1 ist eine Ionenquelle dargestellt, die unter relativ geringem Vakuum ($10^{-2}$ Pa) steht. Der Ionenquelle wird $CH_4$ zugeführt, das in ein Plasma 1' aus verschieden geladenen C-Atomen überführt wird.

In der Ionenquelle 1 mit dem Plasma 1', werden verschiedene C-Ionen mit einer mittleren Ladung von $q_m \approx$ +5 erzeugt. Die Ausgangsblende der Ionenquelle liegt auf einem Potential U unter +10 und etwa +60 V. Mit einer Extraktionselektrode 2 und elektrostatischen Extraktionslinse 3, beide auf einem Potential von (z.B.) -20 kV, werden Ionen mit einem Gemisch von Ladungszuständen extrahiert und auf $(20000+U) \cdot q$ eV in einer Druckzone 4 von $10^{-5}$ Pa beschleunigt. Die Extraktionslinse 3 fokussiert diese Ionen durch eine Eintrittsblende 5 in einen doppelfokussierenden Sektormagneten 6 oder ein anderes ionenoptisches Bauelement zwecks q/m-Separation, so daß Ionen eines einzigen Ladungs-

zustandes, z.B. hier $C^{5+}$, durch die Austrittsblende 7 fokussiert werden.

Diese Austrittsblende wirkt gleichzeitig als differentielle Pumpblende, durch die die Ionen in eine Druckzone 8 von etwa $10^{-7}$ Pa eintreten und dort von einer ersten Abbremslinse 9 von $(20000+U)\cdot q$ eV auf z.B. $(1000+U)\cdot q$ eV abgebremst und durch eine zweite differentielle Pumpblende 10 fokussiert werden. Dies erlaubt den Aufbau einer zweiten Abbremslinse 11 und Stationierung einer zu beschichtenden Oberfläche 12 im Ultrahochvakuum von etwa $10^{-9}$ Pa. In der Abbremslinse 11 werden die q/m-selektierten Ionen von $(1000+U)\cdot q$ eV auf U eV abgebremst und treffen mit niedriger Energie auf die Oberfläche 12, die im vorliegenden Fall ein Substrat aus einem Silizium-Einkristall für die Chipherstellung (engl."wafer") ist. Für die thermische Konditionierung der Oberfläche 12 ist eine Heizung 13 und/oder eine Kühlvorrichtung 14 vorzusehen. Um den Anströmwinkel einzustellen, ist eine (schematisch angedeutete) Verstellvorrichtung 21 des Substrates 20 in verschiedenen Orientierungen vorgesehen.

Eine Gas-, Gasgemisch- oder Dampfzufuhr erfolgt in diesem Beispiel durch Düsen 15, die symmetrisch um die Ionenstrahlachse angeordnet sind, um eine homogene Gasanströmung 19 der vom Ionenstrahl 22 getroffenen Oberfläche zu erzielen.

Kurz vor den Düsen 15 sind Ventile 24 (z.B. piezokeramische Ventile) vorgesehen, die eine Pulsung des Gasstromes gestatten. In diesem Beispiel handelt es sich bei den Gasen um ein $CH_4$-$H_2$-Gemisch, um eine Diamant-Beschichtung auf dem Silizium-Einkristall zu erzeugen. Diamant ist eine metastabile Erscheinung des Kohlenstoffs. Er benötigt zur Bildung eine zusätzliche Aktivierungsenergie, die ihm durch die $C^{5+}$-Ionen zugeführt wird. Die potentielle Energie des Ions erzeugt beim Auftreffen in einer sehr kurzen Zeit eine sehr lokale (< einige $mm^2$) elektronische und thermische Aktivierung, die als hohe lokale Temperatur verstanden werden kann. Durch diese hohe, lokale elektronische und thermische Aktivierung wird bei Anwesenheit von H-Atomen der Kohlenstoff in die gewünschte Diamantstruktur umgelagert. Der anschließende sehr rasche Abfall der lokalen elektronischen und thermischen Aktivierung stabilisiert die metastabile Diamantstruktur.

Beispiel 2 (vgl. Figur 1)

Alternativ ist in Fig.I eine Molekularstrahlherstellung eines gewünschten Materials durch Zerstäuben (engl. "sputtering") mit einem $Ar^+$-Ionenstrahl 16 von etwa 1 bis 5 keV kinetischer Energie, der in einer Ar-Ionenquelle 17 erzeugt und auf das zu zerstäubende Material 18 unmittelbar vor der zu beschichtenden Oberfläche 12 geschossen wird. Bei dem zu zerstäubenden Material 18 handelt es sich um z.B. festes Bor, das als Folge des Zerstäubens mit den Ar-Ionen als B- und $B_2$ - Atom- und Molekülstrahl auf eine Metalloberfläche 12 trifft, wo es in Wechselwirkung mit einem Strahl 22 aus niederenergetischen, hochgeladenen Stickstoff-Ionen eine Beschichtung aus Bornitrid (BN) erzeugt. Um eine noch bessere Homogenisierung der Beschichtung zu erzielen, sind Drehungen und Linearverschiebungen des Substrats 20 mit seiner Oberfläche 12 und einer schematisch dargestellten Verstellungsvorrichtung 21 vorgesehen. Je nach Anwendung können auch andere Vakuumbedingungen und andere Beschleunigungs- und Abbremsbedingungen verwendet werden.

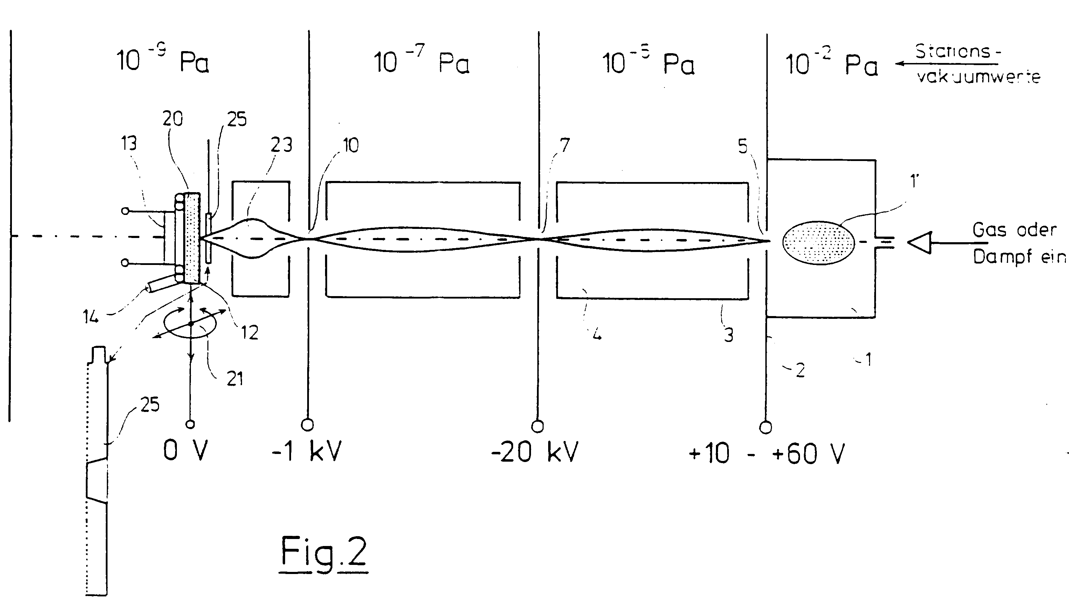

Beispiel 3 (vgl. Figur 2)

Beispiel 3 entspricht in wesentlichen Einzelheiten dem Ausführungsbeispiel 1 bis auf die Auslassung einer q/mSeparationseinheit.

In die Ionenquelle 1 strömt $SiH_4$, das zu Ionen dissoziiert wird. Das gesamte aus dem Plasma 1' der Ionenquelle 1 extrahierte Ladungszustandsgemisch, hier also Si-Ionen, trifft mit $U\cdot q$ eV auf die Oberfläche 12, die hier ein $SiO_2$-Film auf einem Wafer ist. Dies erhöht den Gesamtteilchenstrom auf die Oberfläche 12 und damit die Beschichtungsleistung, erniedrigt im Mittel aber etwas die physikalisch-chemische Aktivierung, da neben hochgeladenen Ionen auch hohe Anteile von nur einfach und zweifach geladenen Ionen im Teilchenstrom enthalten sind. Diese Ionen tragen weniger zur physikalisch-chemischen Aktivierung bei als die hochgeladenen. Es ist daher von Bedeutung, Ionenquellen zu verwenden, die Teilchenströme mit möglichst optimalem mittleren Ladungszustand produzieren können. Optimal ist hierbei ökonomisch und technisch definiert, denn der technische Aufwand der Ionenquellenkonstruktion kann an den niedrigsten Ladungszustand eines ionisierten Elementes angepaßt werden, mit dem effiziente Beschichtungsleistungen entsprechend der Erfindung erzielt werden.

Die Gaszufuhr ist in diesem Ausführungsbeispiel als durchbohrte Düsenmatrix 25 ausgeführt, durch die ein Gemisch aus $SiH_4$ und $N_2$ möglichst homogen den $SiO_2$-Film auf der Oberfläche 12 anströmt, um in Wechselwirkung mit den Si-Ionen eine $Si_3N_4$-Schicht aufzubringen. Da der Ionenstrahl 23 in diesem Beispiel durch die Bohrung der Düsenmatrix 25 fokussiert ist, kann das Substrat 20 mit der Oberfläche 12 vielparametrisch mit der dargestellten Vorrichtung 21 bewegt werden, um entweder eine homogene Flächenbeschichtung oder eine Bechichtungsbeschriftung des $SiO_2$-Films mit $Si_3N_4$ vornehmen zu können. Für die optimale Temperatur der Oberfläche für diese Beschichtung ist eine Heizung 13 und/oder eine Kühlvorrichtung 14 nach einem bekannten System vorzusehen. Je nach Anwendung können auch andere Vakuumbedingungen und andere Beschleunigungs- und Abbremsbedingungen verwendet werden.

Beispiel 4

Beispiel 4 entspricht in wesentlichen Einzelheiten dem Ausführungsbeispiel 1 bis auf die Tatsache, daß der Gesamtaufbau von der Ionenquelle bis zur zu behandelnden Oberfläche in Ultrahochvakuumtechnik ($10^{-9}$ Pa) ausgeführt ist. Dadurch wird größte Reinheit der Anlage bei frei wählbaren Vakuumbedingungen möglich. Bei entsprechender Funktionsweise der Ionenquelle können dann die differentiellen Pumpblenden 7 und 10 entfallen.

Beispiel 5

Beispiel 5 entspricht in wesentlichen Einzelheiten dem Ausführungsbeispiel 3 bis auf die Tatsache, daß der Gesamtaufbau von der Ionenquelle bis zur zu behandelnden Oberfläche in Ultrahochvakuumtechnik ($10^{-9}$ Pa) ausgeführt ist. Dadurch wird größte Reinheit der Anlage bei frei wählbaren Vakuumbedingungen möglich. Bei entsprechender Funktionsweise der Ionenquelle können dann die differentiellen Pumpblenden entfallen.

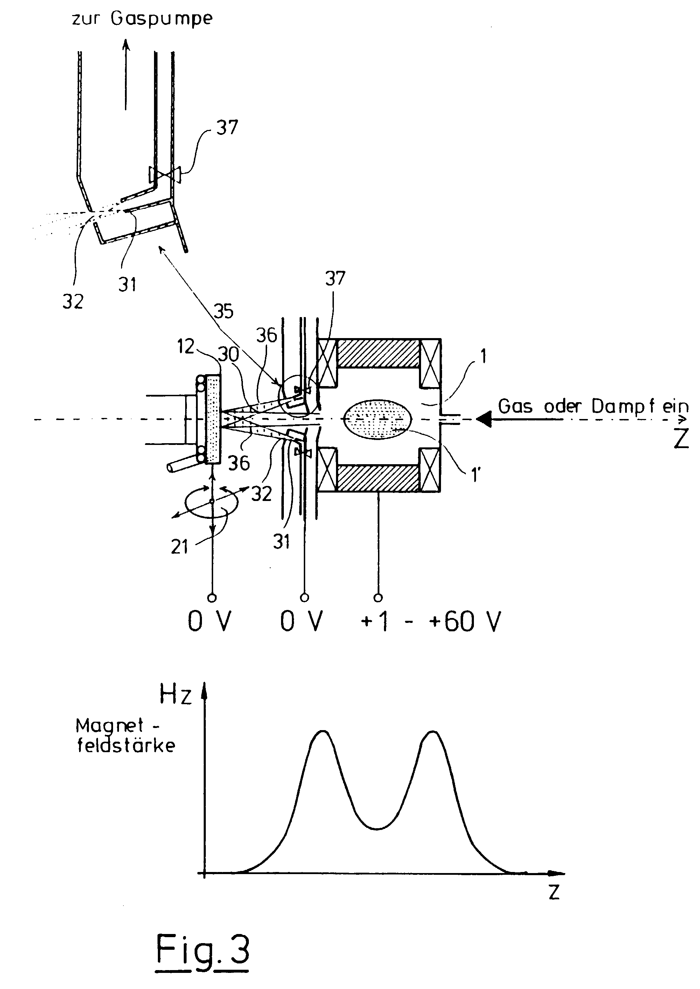

Beispiel 6 (vgl Figur 3)

Ein Ladungszustandsgemisch 30 wird als Teilchenstrom, hier von Fluor-Ionen, aus einer Ionenquelle 1 mit U·q eV direkt in Richtung auf die Oberfläche 12, hier ein Si-Einkristall, extrahiert, wobei die Extraktionsspannung ≈ +1V < U < ≈ +60 V ist. Es findet also gegenüber dem Beispiel 1 keine q/m-Separation und keine ionenoptische Abbildung statt; die differentiellen Pumpstufen entfallen ebenfalls. Es können jedoch, wie in Figur 1, Ventile 37 vorgesehen sein, um den Molekularstrahl zu pulsen.

Der Gesamtteilchenstrom auf die Oberfläche 12 und damit die Ätzleistung sind erhöht, im Mittel ist aber die physikalisch-chemische Aktivierung pro Ion erniedrigt, da je nach Ionenquelle neben hochgeladenen Ionen hohe Anteile von nur einfach und zweifach geladenen Ionen im Teilchenstrom 30 enthalten sind, die geringere Aktivierung erzeugen als hochgeladene. Es ist daher von Bedeu tung, Ionenquellen zu vewenden, die Teilchenströme mit möglichst optimalem mittleren Ladungszustand produzieren können. Optimal ist hierbei, wie bereits erwähnt, ökonomisch und technisch definiert. Der Verlauf der Magnetfeldstärke ist durch das im unteren Teil der Figur 3 dargestellte Diagramm verdeutlicht.

Da Quellen für hochgeladene Ionen meist mit hohem Magnetfeldeinschluß der Ionen und Elektronen arbeiten, ist dieses Ausführungsbeispiel nur dort einsetzbar, wo Magnetstreufelder bei der Weiterbearbeitung der Oberfläche nicht stören. Die Gaszufuhr erfolgt in diesem Ausführungsbeispiel in Form von Molekularstrahlen 36, die mit Düsen 31, Blenden 32 und differentiellen Pumpen 35 definiert werden. Damit wird ein sehr flächen-homogenes Anströmen der Oberfläche, z.B. mit $SiF_4$, erzielt, um durch eine auf der Si-Oberfläche durch lithographische Methoden aufgebrachte Maske durch Wechselwirkung mit den Si-Ionen ein präzises Ätzmuster in die Si-Oberfläche einzuprägen. Die Si-Oberfläche kann vielparametrisch durch die Verstellvorrichtung 21 bewegt werden, um eine noch größere Flächenhomogenität des Ätzens oder bestimmte Ätzprofile zu erreichen. Für die optimale Temperatur der Oberfläche für diese Beschichtung ist eine Heizung 13 und/oder eine Kühlvorrichtung 14 nach einem der bekannten Verfahren vorgesehen. Je nach Anwendung können auch andere Vakuumbedingungen und andere Beschleunigungs- und Abbremsbedingungen z.B. durch andere Magnetfeldstärken-Verteilung verwendet werden.

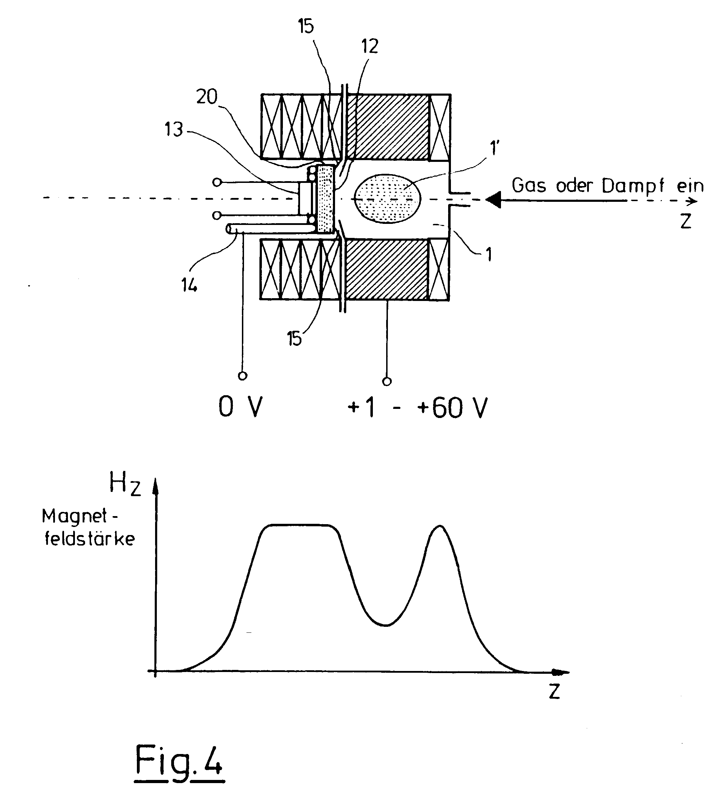

Beispiel 7 (vgl. Figur 4)

Das gesamte Ladungszustandsgemisch eines Plasmas, hier ein Chlor-Plasma, wird mit U·q eV, wobei 1 < U < ≈60 V ist, direkt auf die Oberfläche 12, hier eine Substrat 20 mit einer $Al_2O_3$-Oberfläche, beschleunigt, die eine Wand des Plasmavolumens 1 darstellt. Die Vakuumbedingungen können der jeweiligen Anwendung angepaßt werden. Gegenüber dem Ausführungsbeispiel 6 ist also noch eine weitere Vereinfachung vorgenommen worden. Alle weiteren Erläuterungen des Ausführungsbeispiels 6 sind genauso auf das Ausführungsbeispiel 7 anzuwenden. Wie im Ausführungsbeispiel 6 ist es von Bedeutung, eine Konfiguration der Plasmaherstellung (Plasma 1') zu verwenden, die einen Gehalt an optimalem mittleren Ladungszuständen gewährleistet. Optimal ist hierbei ökonomisch und technisch definiert. Dieses Ausführungsbeispiel ist dem technischen Aufbau des bekannten Plasma-Ätzens (engl. "plasma-etching") nach dem EZR-Prinzip sehr verwandt, bei dem ein Plasma niedrigen mittleren Ladungszustandes mit chemischen Substanzen gemischt wird, um über plasmaunterstützte chemische Reaktionen Oberflächen abzutragen [siehe I, Kapitel 5, Seiten 138 bis 157].

Der entscheidende Unterschied bei dem Ausführungsbeispiel 7 ist die Verwendung eines Plasmas mit hohem mittleren Ladungszustand ( $q_m$ >> 2 ), das zwar auch nach dem EZR-Prinzip erzeugt werden kann, aber einen hohen magnetischen Plasmaeinschluß verlangt, wie er bisher beim Plasma-Ätzen gerade nicht verwandt wird. Die Figur 4 zeigt explizit eine von vielen möglichen Anordnungen mit hohem magnetischen Plasmaeinschluß nach dem EZR-Prinzip mit achsialem Plasmaeinschluß in einem achsialen Magnetfeld, dessen relative magnetische Feldstärke angedeutet ist, und mit einem radialen Plasmaeinschluß durch ein möglichst hohes Multipolmagnetfeld.

Die Gaszufuhr, z.B. $CCl_4$, erfolgt in diesem Ausführungsbeispiel effusiv aus Düsen 15, die symmetrisch um die Achse angeordnet sind und im Bereich der Oberfläche eine erhöhte Dichte von $CCl_4$ erzeugen. Durch eine auf der $Al_2O_3$-Oberfläche durch lithographische Methoden aufgebrachte Maske wird durch Wechselwirkung mit den Cl-Ionen so ein präzises Ätzmuster in die $Al_2O_3$-Oberfläche eingeprägt. Die $Al_2O_3$-Oberfläche

kann gedreht werden, um mit Hilfe der vorwiegend parallel zur Systemachse fliegenden Cl-Ionen bestimmte Ätzprofile zu erzeugen. Die Ionenbewegung parallel zur Systemachse wird durch das homogene Magnetfeld im Bereich der Oberfläche verstärkt. Für die optimale Temperatur der Oberfläche für diese Beschichtung ist eine Heizung 13 und eine Kühlvorrichtung 14 nach einem der bekannten Verfahren vorgesehen. Je nach Anwendung können auch andere Vakuumbedingungen und andere Beschleunigungs- und Abbremsbedingungen verwendet werden.

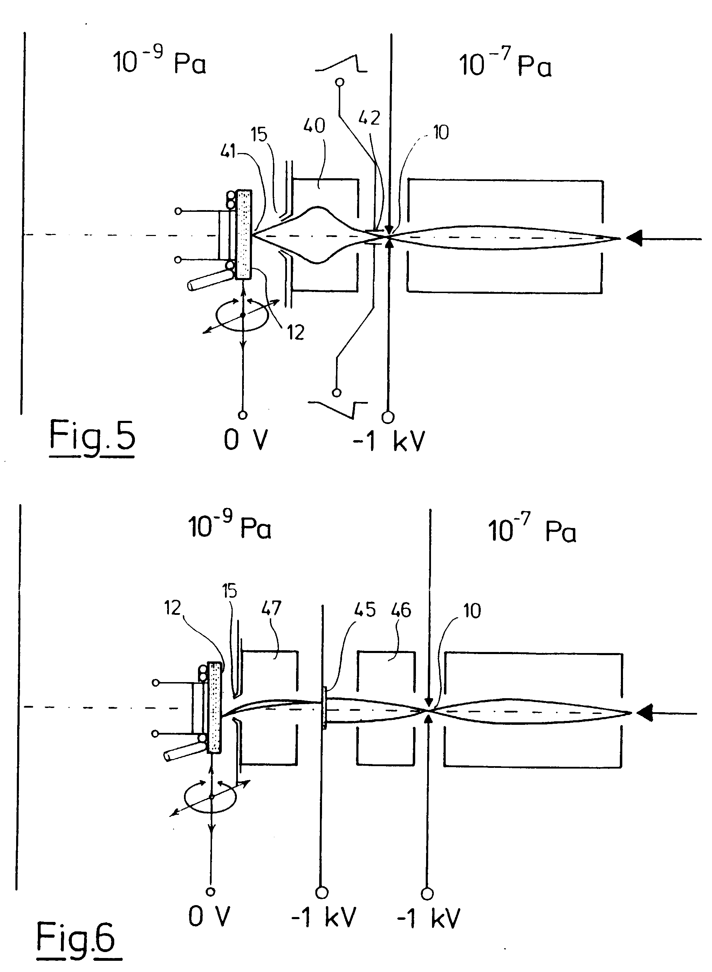

Beispiel 8 (vgl. Figur 5)

Beispiel 8 baut auf den Ausführungsbeispielen 1-5 auf und verwendet kurz vor der Oberfläche 12 ionenoptische Elemente, die eine scharfe Fokussierung des Ionenstrahls, hier z.B. Ti-Ionen, und ein kontrolliertes elektro-magnetisches Führen dieses Fokus auf der Oberfläche oder eine scharfe Abbildung einer teildurchlässigen Maske auf der Oberfläche 12, hier z.B. ein Metall, ermöglichen. Damit kann z.B. bei $N_2$-Gaszufuhr durch Düsen 15 ein TiN-Beschichtungsmuster auf die Oberfläche aufgebracht werden. Da es dafür viele Ausführungsformen gibt, wird in Figur 5 nur eine Möglichkeit für die elektro-magnetische Steuerung eines Ionenstrahlfokus und für die Abbildung einer teildurchlässigen Maske auf die Oberfläche 12 angegeben. Der Vorrichtung gemäß Figur 5 ist als Blende eine differentielle Pumpblende 10 mit sehr kleinem, variablen Radius ausgeführt, die mit ionenoptischen Komponenten 40 auf einem sehr scharfen Fokus 41 abgebildet wird. In Ionenstrahlrichtung hinter dieser Blende ist ein elektro-magnetisches Ablenksystem 42 vorgesehen, das die kontrollierte Führung des Fokus 41 auf der Oberfläche 12 erlaubt.

Beispiel 9 (vgl. Figur 6)

In der Figur 6 ist weiter eine Vorrichtung gezeigt, die eine teildurchlässige Maske 45 durch erste ionenoptische Komponenten 46 parallel ausleuchtet und diese Maske 45 dann mit zweiten ionenoptischen Komponenten scharf auf die Oberfläche abbildet. Mit Hilfe dieser Maske läßt sich z.B. bei Verwendung von $CBrF_3$-Gas und von niederenergetischen, hochgeladenen F-Ionen ein Ätzmuster in eine Pt-Oberfläche einprägen.

**Patentansprüche**

1. Verfahren zur Oberflächenmodifikation durch physikalisch-chemische Reaktionen mit den Verfahrensschritten:

    (a) Kontaktieren einer festen Oberfläche mit kristalliner oder amorpher Struktur mit einem reaktiven, gasförmigen Fluid (Gas, Gasgemisch, Dampf oder Dampfgemisch), das mit der Oberfläche in Wechselwirkung treten soll,
    (b) Einbringen von Aktivierungsenergie in den Kontaktbereich von Fluid und Oberfläche mithilfe von Ionen oder Plasmen, um Reaktionen zwischen den genannten Partnern auszulösen,

    dadurch gekennzeichnet, daß
    die Aktivierungsenergie in Form von wenigstens zweifach geladenen Ionen mit niederer kinetischer Energie oder mit Plasmaströmen, die einen hohen, arithmetisch mittleren Ladungszustand $q_m > 2$ und damit einen hohen Anteil an wenigstens zweifach geladenen Ionen mit niederer kinetischer Energie aufweisen, eingebracht wird, wobei die den Ionen gegebene kinetische Energie lediglich danach bemessen wird, daß den Ionen eine nächste Annäherung an die Atome der Oberfläche, nicht jedoch ein Eindringen in die Oberfläche ermöglicht ist.

2. Verfahren nach Anspruch 1, dadurch gekennzeichnet, daß die Oberflächenmodifikation ein Ätzvorgang ist.

3. Verfahren nach Anspruch 1, dadurch gekennzeichnet, daß die Oberflächenmodifikation ein Beschichten oder Ablagern ist.

4. Verfahren nach einem der vorhergehenden Ansprüche, dadurch gekennzeichnet, daß die Fluide die Oberfläche in Form von Molekularstrahlen im Hoch- oder Ultrahochvakuum flächen-homogen derart unter wählbaren Winkel anströmen, daß die niedernergetischen, hochgeladenen Ionen aus einem Vakuum-Bereich kommend eine begrenzte Gasschicht durchlaufen und dann auf die Oberfläche auftreffen.

5. Verfahren nach einem der Ansprüche 1 bis 4, dadurch gekennzeichnet, daß die Reaktion bei Temperaturen der Oberfläche bei beliebigen Temperaturen, speziell bei Temperaturen deutlich unter 600° C bis unter 0° C erfolgt.

6. Verfahren nach einem der Ansprüche 1 bis 5, dadurch gekennzeichnet, daß eine oder mehrere Monolagen eines auf der Oberfläche adsorbierten reaktiven Fluids durch niederenergetische, hochgeladene Ionen physikalisch-chemisch aktiviert werden.

7. Verfahren nach Anspruch 1 und 6, dadurch gekennzeichnet, daß der Zufluß und das Adsorbieren des reaktiven Fluids unter Berücksichtigung der Aktivierung der Ionenstromdichte derart angepaßt wird, daß die Ionen im Mittel immer mit einer frischen Monolage des adsorbierten reaktiven Fluids wechselwirken, wobei bei kontinuierlichem Ionenstrom das reaktive Fluid in Form von Pulsen definierter Mengen derart an der Oberfläche adsorbiert werden kann, daß jeweils eine Pulsmenge einer bis drei Monolagen an adsorbiertem Fluid auf der Oberflächen entspricht,

oder

das reaktive, gasförmige Fluid und die niederenergetischen, hochgeladenen Ionen in Form von intermittierenden Pulsen definierter Mengen auf die Oberflächen treffen, wobei jede Menge eines Fluidpulses einer bis drei zu adsorbierten Fluid-Monolagen entspricht und die Menge eines Ionenpulses der erforderlichen Aktivierungsenergie dieser adsorbierten Monolagen angepaßt ist.

8. Verfahren nach einem der vorhergenden Ansprüche, dadurch gekennzeichnet, daß reaktive Fluide durch Zerstäuben festen Materials, z.B. von Bor, durch Ionen hoher kinetischer Energie in unmittelbarer Nähe der zu modifizierenden Oberfläche erzeugt werden.

9. Verfahren nach einem der vorhergehenden Ansprüche, dadurch gekennzeichnet, daß bei einem Ätzprozeß oder Beschichtungsprozeß anfangs mit relativ hohen kinetischen Energien der hochgeladenen Ionen begonnen wird und im weiteren Verlauf des Ätzprozesses auf sehr niedrige kinetische Energien übergegangen wird, um so beim Ätzen zu Beginn in tiefere Schichten des Substrates einzudringen und beim Beschichten zu Beginn ein gutes Haften der Beschichtung durch Fehlstellen-Verzahnung mit dem Substrat zu erzielen.

10. Verfahren nach einem der vorhergehenden Ansprüche, dadurch gekennzeichnet, daß zur Einbringung von Energie Ionen eines Elementes verwendet werden, das beim Beschichten einen wesentlichen Bestandteil der aufzubringenden Beschichtung ausmacht oder das beim Ätzen einem wesentlichen Bestandteil der zu ätzenden Substrat-Oberfläche entspricht.

11. Verfahren nach einem der vorhergehenden Ansprüche, dadurch gekennzeichnet, daß hochgeladene Ionen in einer Ionenquelle erzeugt und extrahiert werden, eventuell, aber nicht notwendigerweise nach ihrem Verhältnis q/m (Ladungs- zu Massenverhältnis) separiert werden, ionenoptisch zu einer Prozeßkammer transportiert und vor der zu modifizierenden Oberfläche auf niedrigere Energie pro Ladung abgebremst werden.

12. Verfahren nach einem der vorhergehenden Ansprüche, dadurch gekennzeichnet, daß der Auftreffwinkel, der Auftreffort und die Auftrefffläche (Fokus) der Ionen auf die zu modifizierende Oberfläche steuerbar ist.

13. Verfahren nach einem der vorhergehenden Ansprüche, dadurch gekennzeichnet, daß die hochgeladenen Ionen in einem Bereich mit magnetischen Plasmaeinschluß durch Zufuhr von Energie durch Elektronenstrahlen oder durch Mikrowellen unter Ausnützung der Elektronen-Zyklotron-Resonanz erzeugt werden und das Plasma mit den hochgeladenen Ionen niedriger kinetischer Energie direkt mit der zu modifizierenden Oberfläche in Kontakt gebracht wird.

14. Verfahren nach einem der vorhergehenden Ansprüche, dadurch gekennzeichnet, daß zur Erzeugung der hochgeladenen Ionen eine Elektronen-Zyklotron-Resonanz-Ionenquelle mit magnetischem Plasmaeinschluß, eine Elektronenstoß-Ionenquelle, eine Elektronenstrahl-Ionenquelle, eine Elektronenstrahl-Ionen-Fallen- oder eine Hybrid-Quelle, kombiniert aus wenigstens zweien dieser vier Typen, verwendet wird.

15. Verfahren nach einem der vorhergehenden Ansprüche, dadurch gekennzeichnet, daß mit dem niederenergetischen Strahl hochgeladener Ionen eine teiltransparente Maske ausgeleuchtet wird, die ionenoptisch auf die Oberfläche abgebildet wird, und daß so ein Beschichtungs- oder Ätzabbild der Maske auf der Oberfläche erzeugt wird.

16. Vorrichtung zur Durchführung des Verfahrens nach Ansprüchen 1 bis 7, 9 bis 12 und 14, gekennzeichnet durch eine durchbohrte Düsenmatrix (25), aus deren Bohrung die reaktiven gasförmigen Fluide die Oberfläche anströmen und in deren Bohrung der Ionenstrahl (23) aus niederenergetischen, hochgeladenen Ionen fokussierbar ist.

**Claims**

1. Process for surface-modification by physico-chemical reactions with the steps:

(a) contacting a solid surface having a crystalline or amorphous structure with a reactive, gaseous fluid (gas, gas mixture, vapor or vapor mixture) which is to interact with the surface,

(b) supplying activating energy to the contact area between fluid and surface by means of ions or plasmas, in order to trigger reactions between said partners,

wherein the activating energy is supplied in the form of at least doubly charged ions with low kinetic energy, or by streams of plasmas, which contain a high, arithmetically averaged charge state $q_m > 2$ and therefore a great proportion of at least doubly charged ions with low kinetic energy, where the kinetic energy of the ions is determined by the condition that the ions are allowed to closely approach the atoms at the surface, but not to penetrate the surface, however.

2. The process according to claim 1, wherein the surface modification comprises an etching process.

3. The process according to claim 1, wherein the surface modification comprises a coating or a depositing process.

4. The process according to one of the preceding claims, wherein said fluid is provided as spatially homogeneous atomic or molecular beams directed toward said surface at an arbitrarily selected angle in high or ultra-high vacuum such that said low kinetic energy, highly charged ions are injected from a region of vacuum, traverse a limited region of gas layer, and then impinge said surface.

5. The process according to one of the claims 1 to 4, wherein the reaction takes place at arbitrary temperatures of the surface, especially at temperatures significantly below 600° C down to below 0° C.

6. The process according to one of the claims 1 to 5, wherein one or several mono-layers of said fluid are adsorbed at said surface and are physico-chemically activated by said low kinetic energy, highly charged ions.

7. The process according to one of the claims 1 to 6,

wherein the flux and the adsorption of said fluid at said surface is adapted, under consideration of the activation, to the ion beam or plasma density such that said low kinetic energy, highly charged ions statistically always interact on the average with a fresh mono-layer of the adsorbed, said reactive fluid,

where either said reactive fluid may be adsorbed at said surface in the form of pulses of defined quantity during continuous impact of the low kinetic energy, highly charged ion beam, such that the quantity of said fluid in a puls corresponds to one to three mono-layers of adsorbed fluid at said surface,

or the reactive, gaseous fluid and the low kinetic energy, highly charged ions are striking the surface in the form of intermittent pulses, where the quantity of a puls of said fluid corresponds to one to three mono-layers of adsorbed fluid, and the quantity of the ion puls is adapted to the necessary activating energy of these adsorbed mono-layers.

8. The process according to one of the preceding claims, wherein said fluid is produced by sputtering of a solid material, boron for instance, with ions having a high kinetic energy in close proximity to said surface to be modified.

9. The process according to one of the preceding claims, wherein said process of etching or coating is initially started with relatively high kinetic energy of the highly charged ions which is then, during the further course of etching or coating, reduced to very low kinetic energy, in order to efficiently penetrate into deeper layers of the substrate at the beginning of the etching, or to create a good adhesion at the beginning of the coating by linking to crystalline defects, and then to continue etching or coating without penetration of said surface.

10. The process according to one of the preceding claims, wherein highly charged ions of an element are used for the supply of the activating energy which represents a significant constituent of the coating to be deposited, or which represents a significant constituent of said surface to be modified.

11. The process according to one of the preceding claims, wherein said low kinetic energy, highly charged ions are produced in an ion source, extracted, and optionally separated with respect to their ratio charge to mass ratio (q/m), ion-optically transported to a processing chamber, and decelerated to said low kinetic energy per charge in front of said surface to be modified.

12. The process according to one of the preceding claims, wherein the angle of incidence, the position of impact, and the size of impact spot of the said low kinetic energy, highly charged ions on said surface to be modified are controlled.

13. The process according to one of the preceding claims, wherein said low kinetic energy, highly charged ions are produced in a region with magnetic plasma confinement by feeding energy via electron beams or via micro-waves employing electron cyclotron resonance, and wherein the plasma with low kinetic energy, highly charged ions is brought into direct contact with said surface to be modified.

14. The process according to one of the preceding claims,
    wherein one or more devices selected from the group consisting of an electron-cyclotron-resonance ion source with magnetic plasma confinement, an electron impact ion source, an electron beam ion source, or a hybrid source, combined from at least two of the group, is used to produce said low kinetic energy, highly charged ions.

15. The process according to one of the preceding claims,
    wherein the low kinetic energy, highly charged ions irradiate a perforated mask having a pattern which is ion-optically imaged onto said surface, such that an etched or coated image of said mask pattern is produced on said surface.

16. The process according to one of the claims 1 to 7, 9 to 12 and 14,
    wherein said fluid homogeneously streams out of a matrix of nozzles, having holes, on to said surface, and wherein said low kinetic energy, highly charged ions are injected from a region of high vacuum and impinge said surface through said holes of said matrix of nozzles.

## Revendications

1. Procédé de modification de surfaces par réactions physico-chimiques qui comprend les étapes consistant à:

    (a) amener au contact d'une surface solide à structure cristalline ou amorphe un fluide gazeux réactif (gaz, mélange gazeux, vapeur ou mélange de vapeurs), qui doit entrer en interaction avec la surface;
    (b) introduire une énergie d'activation dans la zone de contact entre le fluide et la surface au moyen d'ions ou de plasmas, afin de déclencher des réactions entre les partenaires cités,

    caractérisé en ce que
    l'énergie d'activation est introduite sous la forme d'ions au moins doublement chargés à faible énergie cinétique ou à l'aide de courants de plasma qui présentent un état de charge moyenne arithmétique élevée $q_m > 2$ et donc une fraction élevée d'ions au moins doublement chargés à faible énergie cinétique, l'énergie cinétique communiquée aux ions étant simplement déterminée de manière à permettre aux ions de s'approcher très près de la surface mais non d'y pénétrer.

2. Procédé selon la revendication 1, caractérisé en ce que la modification de surface est un processus de gravure.

3. Procédé selon la revendication 1, caractérisé en ce que la modification de surface est un revêtement ou un dépôt.

4. Procédé selon l'une quelconque des revendications précédentes, caractérisé en ce que les fluides sont incidents sur la surface selon un angle à sélectionner, sous la forme de faisceaux moléculaires homogènes sur la surface, sous un vide élevé ou un ultravide d'une manière telle que les ions hautement chargés à faible énergie parcourent en sortant d'une zone de vide une couche gazeuse limitée et atteignent ensuite la surface.

5. Procédé selon l'une des revendications 1 à 4, caractérisé en ce que la réaction s'effectue à des températures de la surface qui sont des températures choisies à volonté, spécialement à des températures qui sont de façon significative inférieures à 600°C et peuvent être inférieures à 0°C.

6. Procédé selon l'une des revendications 1 à 5, caractérisé en ce que une ou plusieurs mono-couches d'un fluide réactif adsorbé à la surface sont activées de façon physico-chimique au moyen d'ions hautement chargés à faible énergie cinétique.

7. Procédé selon les revendications 1 et 6, caractérisé en ce que l'amenée du fluide réactif et son adsorption sont adaptées à la densité de courant d'ions, en tenant compte de l'activation, d'une manière telle que les ions interagissent toujours dans le milieu avec une mono-couche fraîche du fluide réactif adsorbé, étant entendu que, pour un courant continu d'ions, le fluide réactif peut être adsorbé sous la forme de doses définies par des impulsions d'une manière telle que chaque dose d'impulsion correspond respectivement à une à trois mono-couches de fluide adsorbé sur les surfaces, ou
    le fluide gazeux réactif et les ions hautement chargés à faible énergie cinétique atteignent les surfaces sous forme de doses définies par des impulsions intermittentes, chacune des doses d'une impulsion de fluide correspondant à une à trois mono-couches adsorbées de fluide et la dose d'une impulsion ionique étant adaptée à l'énergie d'activation nécessaire de cette mono-couche adsorbée.

8. Procédé selon l'une des revendications précédentes caractérisé en ce que les fluides réactifs sont engendrés par pulvérisation d'une matière solide, par exemple du bore, par des ions à énergie cinétique élevée au voisinage immédiat de la surface à modifier.

9. Procédé selon l'une des revendications précédentes, caractérisé en ce que le procédé commence, pour un processus de gravure ou un processus de recouvrement, par des énergies cinétiques relativement élevées des ions hautement chargés et qu'il passe à des énergies cinétiques très basses, lors de la poursuite du processus de gravure, afin de pénétrer ainsi au début d'une gravure dans les couches plus profondes du substrat et d'atteindre au début d'un revêtement une bonne adhérence du revêtement par imbrication d'emplacements défectueux avec le substrat.

10. Procédé selon l'une des revendications précédentes, caractérisé par une utilisation, pour introduire l'énergie, d'ions d'un élément qui constitue lors d'un revêtement un composant essentiel de la couche de revêtement ou qui correspond lors d'une gravure à une composante essentielle de la surface de substrat à graver.

11. Procédé selon l'une des revendications précédentes, caractérisé en ce que des ions hautement chargés sont engendrés dans une source d'ions et sont extraits, sont éventuellement mais non nécessairement séparés selon leur rapport q/m (rapport entre la charge et la masse), sont transportés par des moyens d'optique ionique vers une chambre de processus et sont freinés avant de parvenir à la surface à modifier à une énergie moindre par charge.

12. Procédé selon l'une des revendications précédentes, caractérisé en ce que l'angle d'incidence, le lieu d'incidence et la surface d'incidence (foyer) des ions sur la surface à modifier sont réglables.

13. Procédé selon l'une des revendications précédentes, caractérisé en ce que les ions hautement chargés sont engendrés en utilisant la résonnance à cyclotron d'électrons dans une zone à confinement magnétique par plasma par amenée d'énergie au moyen de faisceaux d'électrons ou de micro-ondes et en ce que le plasma à ions hautement chargés à énergie cinétique plus faible est directement amené au contact de la surface à modifier.

14. Procédé selon l'une des revendications précédentes, caractérisé par une utilisation, pour la génération des ions hautement chargés, d'une source d'ions à résonnance de cyclotron d'électrons à confinement magnétique de plasma, d'une source d'ions par choc d'électrons, d'une source d'ions à faisceau d'électrons, d'une source à piège à ions à faisceau d'électrons ou d'une source hybride, combinée à partir d'au moins deux des quatre types.

15. Procédé selon l'une des revendications précédentes, caractérisé en ce qu'un masque partiellement transparent qui est reproduit par optique ionique sur la surface est exposé au faisceau d'ions hautement chargés à faible énergie et qu'une reproduction du masque, par revêtement ou par gravure, est ainsi engendrée sur la surface.

16. Dispositif de mise en oeuvre du procédé selon l'une des revendications 1 à 7, 9 à 12 et 14, caractérisé par une matrice perforée (25) d'injecteurs, à partir de l'alésage de laquelle les fluides gazeux viennent balayer la surface et dans l'alésage de laquelle le faisceau d'ions (23) constitué d'ions hautement chargés à faible énergie cinétique peut être focalisé.

$10^{-9}$Pa $\qquad$ $10^{-7}$Pa $\qquad\qquad$ Stations-Vakuumwerte

17  16  24  15
    18  11  10  8  7

20

13
14

21  19  15  22  9
   12

0 V $\qquad$ -1 kV $\qquad$ -20 kV

6 $\qquad$ $10^{-5}$Pa

5

4 $\qquad$ $10^{-5}$ Pa

3

$\leqslant$ +10 - +60 V $\qquad$ 2 $\qquad$ $10^{-2}$ Pa

1'

1

Gas (Dampf) ein

Fig.1

EP 0 625 218 B1

$10^{-9}$ Pa      $10^{-7}$ Pa      $10^{-5}$ Pa      $10^{-2}$ Pa   ← Stations- vakuumwerte

Gas oder Dampf ein

0 V      -1 kV      -20 kV      +10 - +60 V

<u>Fig.2</u>

EP 0 625 218 B1

zur Gaspumpe

Gas oder Dampf ein

Z

0 V   0 V   +1 - +60 V

Hz

Magnet-feldstärke

Z

## Fig.3

15 12

20

13 1'

Gas oder Dampf ein

Z

14

1

15

0 V        +1 - +60 V

$H_Z$

Magnetfeldstärke

Z

# Fig.4

Fig.5

Fig.6